(19) **Europäisches Patentamt**

**European Patent Office**

**Office européen des brevets**

(11) **EP 0 560 931 B1**

(12) **EUROPEAN PATENT SPECIFICATION**

(45) Date of publication and mention
of the grant of the patent:
**01.03.2000 Bulletin 2000/09**

(51) Int. Cl.7: **G10L 19/04**

(86) International application number:
**PCT/US91/09135**

(21) Application number: **92902772.0**

(22) Date of filing: **04.12.1991**

(87) International publication number:
**WO 92/10830 (25.06.1992 Gazette 1992/14)**

(54) **METHODS FOR SPEECH QUANTIZATION AND ERROR CORRECTION**

VERFAHREN FÜR SPRACHQUANTISIERUNG UND FEHLERKORREKTUR

PROCEDES DE QUANTIFICATION DE SIGNAL VOCAL ET DE CORRECTION D'ERREURS DANS LEDIT SIGNAL

(84) Designated Contracting States:
**CH DE FR GB IT LI**

(30) Priority: **05.12.1990 US 624878**

(43) Date of publication of application:
**22.09.1993 Bulletin 1993/38**

(60) Divisional application:
**98203160.1 / 0 893 791**

(73) Proprietor:
**DIGITAL VOICE SYSTEMS, INC.**
**Winchester, MA 01890 (US)**

(72) Inventors:
• **HARDWICK, John, C.**
**Cambridge, MA 02141 (US)**
• **LIM, Jae, S.**
**Winchester, MA 01890 (US)**

(74) Representative:
**Deans, Michael John Percy**
**Lloyd Wise, Tregear & Co.,**
**Commonwealth House,**
**1-19 New Oxford Street**
**London WC1A 1LW (GB)**

(56) References cited:
**EP-A- 0 123 456**     **US-A- 4 276 647**
**US-A- 4 873 689**     **US-A- 4 975 957**
**US-A- 5 023 910**

• **PATENT ABSTRACTS OF JAPAN vol. 14 no. 498 (P-1124) ,30 October 1990 & JP-A-02 203400 (JAPAN RADIO) 13 August 1990,**
• **INTERNATIONAL CONFERENCE ON ACOUSTICS, SPEECH AND SIGNAL PROCESSING 83, BOSTON, MA, US, 14-16 APRIL 1983, vol. 1, 1983, NEW YORK, NY, USA, IEEE, USA, pages 61-63, ROUCOS S ET AL. 'A segment vocoder at 150 B/S'**
• **J. HARDWICK, "A 4.8 KBPS Multi-Band Excitation Speech Coder", May 1988, by Massachusetts Institute of Technology, Cambridge, Massachusetts, see pages 14 to 58.**
• **GRIFFIN et al, "Multiband Excitation Vocoder", Reprinted from IEEE Transactions on Acoustics, Speech, and Signal Processing, Volume 36, No. 8, August 1988, see figures 3 and 11.**

Remarks:
The file contains technical information submitted after the application was filed and not included in this specification

**Description**

This invention relates to a method for encoding speech, and provides examples of methods which can preserve the quality of speech during the presence of bit errors in a speech signal.

Relevant publications include: J. L. Flanagan. Speech Analysis, Synthesis and Perception, Springer-Verlag, 1972, pp. 378-386, (discusses phase vocoder - frequency-based speech analysis-synthesis system); Quatieri, et al., "Speech Transformations Based on a Sinusoidal Representation", IEEE TASSP, Vol. ASSP34, No. 6, Dec. 1986, pp. 1449-1986, (discusses analysis-synthesis technique based on a sinusoidal representation); Griffin, "Multiband Excitation Vocoder", Ph.D. Thesis, M.I.T, 1987, (discusses an 8000 bps Multi-Band Excitation speech coder): Griffin. et al., "A High Quality 9.6 kbps Speech Coding System", Proc. ICASSP 86, pp. 125-128, Tokyo, Japan, April 13-20, 1986, (discusses a 9600 bps Multi-Band Excitation speech coder);Griffin. et al., "A New Model-Based Speech Analysis/Synthesis System", Proc. ICASSP S5, pp. 513-516. Tampa, FL., March 26-29. 1985, (discusses Multi-Band Excitation speech model); Hardwick, "A 4.8 kbps Multi-Band Excitation Speech Coder", S.M. Thesis, M.I.T, May 1988, (discusses a 4800 bps Multi-Band Excitation speech coder); McAulay et al., "Mid-Rate Coding Based on a Sinusoidal Representation of Speech". Proc. ICASSP 85, pp. 945-948. Tampa, FL., March 26-29. 1985, (discusses speech coding based on a sinusoidal representation); Campbell et al., "The New 4800 bps Voice Coding Standard", Mil Speech Tech Conference, Nov. 1989. (discusses error correction in low rate speech coders); Campbell et al., "CELP Coding for Land Mobile Radio Applications", Proc. ICASSP 90. pp. 465-468, Albequerque, NM. April 3-6, 1990, (discusses error correction in low rate speech coders); Levesque et al., Error-Control Techniques for Digital Communication, Wiley, 1985, pp. 157-170. (discusses error correction in general); Jayant et al., Digital Coding of Waveforms. Prentice-Hall, 1984 (discusses quantization in general); Makhoul, et.al. "Vector Quantization in Speech Coding". Proc. IEEE. 1985, pp. 1551-1588 (discusses vector quantization in general); Jayant et al.. "Adaptive Postfiltering of 16 kb/s-ADPCM Speech", Proc. ICASSP 86, pp. 829-832. Tokyo, Japan. April 13-20, 1986, (discusses adaptive postfiltering of speech). The contents of these publications are incorporated herein by reference.

The problem of speech coding (compressing speech into a small number of bits) has a large number of applications, and as a result has received considerable attention in the literature. One class of speech coders (vocoders) which have been extensively studied and used in practice is based on an underlying model of speech. Examples from this class of vocoders include linear prediction vocoders, homomorphic vocoders, and channel vocoders. In these vocoders, speech is modeled on a short-time basis as the response of a linear system excited by a periodic impulse train for voiced sounds or random noise for unvoiced sounds. For this class of vocoders, speech is analyzed by first segmenting speech using a window such as a Hamming window. Then, for each segment of speech, the excitation parameters and system parameters are estimated and quantized. The excitation parameters consist of the voiced/unvoiced decision and the pitch period. The system parameters consist of the spectral envelope or the impulse response of the system. In order to reconstruct speech, the quantized excitation parameters are used to synthesize an excitation signal consisting of a periodic impulse train in voiced regions or random noise in unvoiced regions. This excitation signal is then filtered using the quantized system parameters.

Even though vocoders based on this underlying speech model have been quite successful in producing intelligible speech, they have not been successful in producing high-quality speech. As a consequence, they have not been widely used for high-quality speech coding. The poor quality of the reconstructed speech is in part due to the inaccurate estimation of the model parameters and in part due to limitations in the speech model.

A new speech model, referred to as the Multi-Band Excitation (MBE) speech model, was developed by Griffin and Lim in 1984. Speech coders based on this new speech model were developed by Griffin and Lim in 1986, and they were shown to be capable of producing high quality speech at rates above 8000 bps (bits per second). Subsequent work by Hardwick and Lim produced a 4800 bps MBE speech coder which was also capable of producing high quality speech. This 4800 bps speech coder used more sophisticated quantization techniques to achieve similar quality at 4800 bps that earlier MBE speech coders had achieved at 8000 bps.

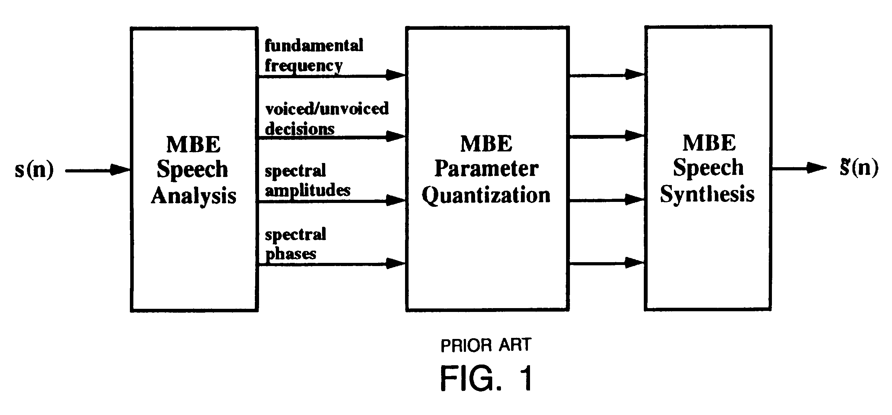

The 4800 bps MBE speech coder used a MBE analysis/synthesis system to estimate the MBE speech model parameters and to synthesize speech from the estimated MBE speech model parameters. A discrete speech signal, denoted by $s(n)$, is obtained by sampling an analog speech signal. This is typically done at an 8 kHz. sampling rate, although other sampling rates can easily be accommodated through a straight-forward change in the various system parameters. The system divides the discrete speech signal into small overlapping segments or segments by multiplying $s(n)$ with a window $w(n)$ (such as a Hamming window or a Kaiser window) to obtain a windowed signal $s_w(n)$. Each speech segment is then analyzed to obtain a set of MBE speech model parameters which characterize that segment. The MBE speech model parameters consist of a fundamental frequency, which is equivalent to the pitch period, a set of voiced/unvoiced decisions, a set of spectral amplitudes, and optionally a set of spectral phases. These model parameters are then quantized using a fixed number of bits for each segment. The resulting bits can then be used to reconstruct the speech signal, by first reconstructing the MBE model parameters from the bits and then synthesizing the speech from the model parameters. A block diagram of a typical MBE speech coder is shown in Figure 1.

The 4800 bps MBE speech coder required the use of a sophisticated technique to quantize the spectral amplitudes. For each speech segment the number of bits which could be used to quantize the spectral amplitudes varied between 50 and 125 bits. In addition the number of spectral amplitudes for each segment varies between 9 and 60. A quantization method was devised which could efficiently represent all of the spectral amplitudes with the number of bits available for each segment. Although this spectral amplitude quantization method was designed for use in an MBE speech coder the quantization techniques are equally useful in a number of different speech coding methods, such as the Sinusoidal Transform Coder and the Harmonic Coder For a particular speech segment, $\hat{L}$ denotes the number of spectral amplitudes in that segment. The value of $\hat{L}$ is derived from the fundamental frequency, $\hat{\omega}_0$, according to the relationship,

$$\dot{L} = \lfloor \beta \lfloor \frac{\pi}{\tilde{\omega}_0} + .25 \rfloor \rfloor \qquad (1)$$

where $0 \leq \beta \leq 1.0$ determines the speech bandwidth relative to half the sampling rate. The function $\lfloor x \rfloor$, referred to in Equation (1), is equal to the largest integer less than or equal to $x$. The $\hat{L}$ spectral amplitudes are denoted by $\hat{M}_l$ for $1 \leq l \leq \hat{L}$. where $\hat{M}_1$ is the lowest frequency spectral amplitude and $\hat{M}_L$ is the highest frequency spectral amplitude.

The spectral amplitudes for the current speech segment are quantized by first calculating a set of prediction residuals which indicate the amount the spectral amplitudes have changed between the current speech segment and the previous speech segment. If $\hat{L}^0$ denotes the number of spectral amplitudes in the current speech segment and $\hat{L}^{-1}$ denotes the number of spectral amplitudes in the previous speech segment, then the prediction residuals, $\hat{T}_l$ for $1 \leq l \leq \hat{L}^0$ are given by,

$$\dot{T}_l = \begin{cases} \log_2 \hat{M}_l^0 - \gamma \cdot \tilde{M}_l^{-1} & \text{if } l \leq \dot{L}^{-1} \\ \log_2 \hat{M}_l^0 - \gamma \cdot \tilde{M}_{\hat{L}^{-1}}^{-1} & \text{otherwise} \end{cases} \qquad (2)$$

where $\hat{M}_l^0$ denotes the spectral amplitudes of the current speech segment and $\tilde{M}_l^{-1}$ denotes the quantized spectral amplitudes of the previous speech segment. The constant $\gamma$ is typically equal to .7, however any value in the range $0 \leq \gamma \leq 1$ can be used.

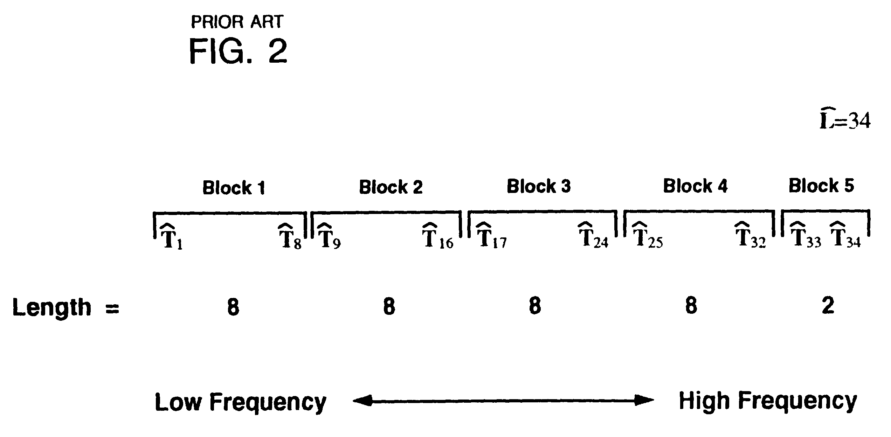

The prediction residuals are divided into blocks of $K$ elements, where the value of $K$ is typically in the range $4 \leq K \leq 12$. If $\hat{L}$ is not evenly divisible by $K$, then the highest frequency block will contain less than $K$ elements. This is shown in Figure 2 for $\hat{L} = 34$ and $K = 8$.

Each of the prediction residual blocks is then transformed using a Discrete Cosine Transform (DCT) defined by,

$$X(k) = \frac{1}{J} \sum_{j=0}^{J-1} x(j) \cos[\frac{\pi k(j + \frac{1}{2})}{J}] \qquad (3)$$

The length of the transform for each block, $J$, is equal to the number of elements in the block. Therefore, all but the highest frequency block are transformed with a DCT of length $K$, while the length of the DCT for the highest frequency block is less than or equal to $K$, Since the DCT is an invertible transform, the $\hat{L}$ DCT coefficients completely specify the spectral amplitude prediction residuals for the current segment.

The total number of bits available for quantizing the spectral amplitudes is divided among the DCT coefficients according to a bit allocation rule. This rule attempts to give more bits to the perceptually more important low-frequency blocks, than to the perceptually less important high-frequency blocks. In addition the bit allocation rule divides the bits within a block to the DCT coefficients according to their relative long-term variances. This approach matches the bit allocation with the perceptual characteristics of speech and with the quantization properties of the DCT.

Each DCT coefficient is quantized using the number of bits specified by the bit allocation rule. Typically, uniform quantization is used, however non-uniform or vector quantization can also be used. The step size for each quantizer is determined from the long-term variance of the DCT coefficients and from the number of bits used to quantize each coefficient. Table 1 shows the typical variation in the step size as a function of the number of bits, for a long-term variance equal to $\sigma^2$.

Once each DCT coefficient has been quantized using the number of bits specified by the bit allocation rule, the binary representation can be transmitted, stored, etc..

| Number of Bits | Step Size |
|---|---|
| 1 | $1.2\sigma$ |
| 2 | $.85\sigma$ |
| 3 | $.65\sigma$ |
| 4 | $.42\sigma$ |
| 5 | $.28\sigma$ |
| 6 | $.14\sigma$ |
| 7 | $.07\sigma$ |
| 8 | $.035\sigma$ |
| 9 | $.0175\sigma$ |
| 10 | $.00875\sigma$ |
| 11 | $.00438\sigma$ |
| 12 | $.00219\sigma$ |
| 13 | $.00110\sigma$ |
| 14 | $.000550\sigma$ |
| 15 | $.000275\sigma$ |
| 16 | $.000138\sigma$ |

Table 1: Step Size of Uniform Quantizers

depending on the application. The spectral amplitudes can be reconstructed from the binary representation by first reconstructing the quantized DCT coefficients for each block, performing the inverse DCT on each block, and then combining with the quantized spectral amplitudes of the previous segment using the inverse of Equation (2). The inverse DCT is given by,

$$x(k) = \sum_{j=0}^{J-1} \alpha(j) X(j) \cos[\frac{\pi j(k + \frac{1}{2})}{J}] \tag{4}$$

where the length, $J$, for each block is chosen to be the number of elements in that block, $\alpha(j)$ is given by,

$$\alpha(j) = \begin{cases} 1 & \text{if } j = 0 \\ 2 & \text{otherwise} \end{cases} \tag{5}$$

One potential problem with the 4800 bps MBE speech coder is that the perceived quality of the reconstructed speech may be significantly reduced if bit errors are added to the binary representation of the MBE model parameters. Since bit errors exist in many speech coder applications, a robust speech coder must be able to correct, detect and/or tolerate bit errors. One technique which has been found to be very successful is to use error correction codes in the binary representation of the model parameters. Error correction codes allow infrequent bit errors to be corrected, and they allow the system to estimate the error rate. The estimate of the error rate can then be used to adaptively process the model parameters to reduce the effect of any remaining bit errors. Typically, the error rate is estimated by counting the number of errors corrected (or detected) by the error correction codes in the current segment, and then using this information to update the current estimate of error rate. For example if each segment contains a (23,12) Golay code which can correct three errors out of the 23 bits, and $\varepsilon_T$ denotes the number of errors (0-3) which were corrected in the current segment, then the current estimate of the error rate, $\varepsilon_R$, is updated according to:

$$\varepsilon_R = 3\varepsilon_R + (1 - 3)\frac{\varepsilon_T}{23} \tag{6}$$

where $\beta$ is a constant in the range $0 \leq \beta \leq 1$ which controls the adaptability of $\varepsilon_R$.

When error correction codes or error detection codes are used, the bits representing the speech model parameters are converted to another set of bits which are more robust to bit errors. The use of error correction or detection codes typically increases the number of bits which must be transmitted or stored. The number of extra bits which must be transmitted is usually related to the robustness of the error correction or detection code. In most applications, it is desirable to minimize the total number of bits which are transmitted or stored. In this case the error correction or detection codes must be selected to maximize the overall system performance.

Another problem in this class of speech coding systems is that limitations in the estimation of the speech model parameters may cause quality degradation in the synthesized speech. Subsequent quantization of the model parameters induces further degradation. This degradation can take the form of reverberant or muffled quality to the synthesized speech. In addition background noise or other artifacts may be present which did not exist in the orignal speech. This form of degradation occurs even if no bit errors are present in the speech data, however bit errors can make this problem worse. Typically speech coding systems attempt to optimize the parameter estimators and parameter quantizers to minimize this form of degradation. Other systems attempt to reduce the degradations by post-filtering. In post-filtering the output speech is filtered in the time domain with an adaptive all-pole filter to sharpen the format peaks. This method does not allow fine control over the spectral enhancement process and it is computationally expensive and inefficient for frequency domain speech coders.

The invention described herein applies to many different speech coding methods, which include but are not limited to linear predictive speech coders, channel vocoders, homomorphic vocoders, sinusoidal transform coders, multi-band excitation speech coders and improved multiband excitation (IMBE) speech coders. For the purpose of describing this invention in detail, we use the 6.4 kbps IMBE speech coder which has recently been standardized as part of the INMARSAT-M (International Marine Satellite Organization) satellite communication system. This coder uses a robust speech model which is referred to as the Multi-Band Excitation (MBE) speech model.

Efficient methods for quantizing the MBE model parameters have been developed. These methods are capable of quantizing the model parameters at virtually any bit rate above 2 kbps. The 6.4 kbps IMBE speech coder used in the INMARSAT-M satellite communication system uses a 50 Hz frame rate. Therefore 128 bits are available per frame. Of these 128 bits. 45 bits are reserved for forward error correction. The remaining 83 bits per frame are used to quantize the MBE model parameters, which consist of a fundamental frequency $\hat{\omega}_0$, a set of V/UV decisions $\hat{v}_k$ for $1 \leq k \leq \hat{K}$, and a set of spectral amplitudes $\hat{M}_l$ for $1 \leq l \leq \hat{L}$. The values of $\hat{K}$ and $\hat{L}$ vary depending on the fundamental frequency of each frame. The 83 available bits are

| Parameter | Number of Bits |
|---|---|
| Fundamental Frequency | 8 |
| Voiced/Unvoiced Decisions | $\hat{K}$ |
| Spectral Amplitudes | $75 - \hat{K}$ |

Table 2: Bit Allocation Among Model Parameters

divided among the model parameters as shown in Table 2.

The fundamental frequency is quantized by first converting it to its equivalent pitch period using Equation (7).

$$\hat{P}_0 = \frac{2\pi}{\hat{\omega}_0} \tag{7}$$

The value of $\hat{P}_0$ is typically restricted to the range $20 \leq \hat{P}_0 \leq 120$ assuming an 8 kHz sampling rate. In the 6.4 kbps IMBE system this parameter is uniformly quantized using 8 bits and a step size of .5. This corresponds to a pitch accuracy of one half sample.

The $\hat{K}$ V/UV decisions are binary values. Therefore they can be encoded using a single bit per decision. The 6.4 kbps system uses a maximum of 12 decisions, and the width of each frequency band is equal to $3\hat{\omega}_0$. The width of

the highest frequency band is adjusted to include frequencies up to 3.8 kHz.

The spectral amplitudes are quantized by forming a set of prediction residuals. Each prediction residual is the difference between the logarithm of the spectral amplitude for the current frame and the logarithm of the spectral amplitude representing the same frequency in the previous speech frame. The spectral amplitude prediction residuals are then divided into six blocks each containing approximately the same number of prediction residuals. Each of the six blocks is then transformed with a Discrete Cosine Transform (DCT) and the D.C. coefficients from each of the six blocks are combined into a 6 element Prediction Residual Block Average (PRBA) vector. The mean is subtracted from the PRBA vector and quantized using a 6 bit non-uniform quantizer. The zero-mean PRBA vector is then vector quantized using a 10 bit vector quantizer. The 10 bit PRBA codebook was designed using a k-means clustering algorithm on a large training set consisting of zero-mean PRBA vectors from a variety of speech material. The higher-order DCT coefficients which are not included in the PRBA vector are quantized with scalar uniform quantizers using the $59 - \hat{K}$ remaining bits. The bit allocation and quantizer step sizes are based upon the long-term variances of the higher order DCT coefficients.

There are several advantages to this quantization method. First, it provides very good fidelity using a small number of bits and it maintains this fidelity as $\hat{L}$ varies over its range. In addition the computational requirements of this approach are well within the limits required for real-time implementation using a single DSP such as the AT&T DSP32C. Finally this quantization method separates the spectral amplitudes into a few components, such as the mean of the PRBA vector, which are sensitive to bit errors, and a large number of other components which are not very sensitive to bit errors. Forward error correction can then be used in an efficient manner by providing a high degree of protection for the few sensitive components and a lesser degree of protection for the remaining components. This is discussed in the next section.

The invention features an improved method for quantizing the prediction residuals. The prediction residuals are grouped into blocks, the average of the prediction residuals within each block is determined, the averages of all of the blocks are grouped into a prediction residual block average (PRBA) vector, and the PRBA vector is encoded. In preferred embodiments, the average of the prediction residuals is obtained by adding the spectral amplitude prediction residuals within the block and dividing by the number of prediction residuals within that block, or by computing the DCT of the spectral amplitude prediction residuals within a block and using the first coefficient of the DCT as the average. The PRBA vector is preferably encoded using one of two methods: (1) performing a transform such as the DCT on the PRBA vector and scalar quantizing the transform coefficients: (2) vector quantizing the PRBA vector. Vector quantization is preferably performed by determining the average of the PRBA vector, quantizing said average using scalar quantization, and quantizing the zero-mean PRBA vector using vector quantization with a zero-mean code-book. An advantage of this aspect of the invention is that it allows the prediction residuals to be quantized with less distortion for a given number of bits.

In a preferred aspect, the invention features an improved method for forming the predicted spectral amplitudes. They are based on interpolating the spectral amplitudes of a previous segment to estimate the spectral amplitudes in the previous segment at the frequencies of the current segment. This new method corrects for shifts in the frequencies of the spectral amplitudes between segments, with the result that the prediction residuals have a lower variance, and therefore can be quantized with less distortion for a given number of bits. In preferred embodiments, the frequencies of the spectral amplitudes are fundamental frequency and multiples thereof.

The invention may also feature an improved method for dividing the prediction residuals into blocks. Instead of fixing the length of each block and then dividing the prediction residuals into a variable number of blocks, the prediction residuals are divided into a predetermined number of blocks and the size of the blocks varies from segment to segment. In preferred embodiments, six (6) blocks are used in all segments; the number of prediction residuals in a lower frequency block is not larger than the number of prediction residuals in a higher frequency block; the difference between the number of elements in the highest frequency block and the number of elements in the lowest frequency block is less than or equal to one. This new method more closely matches the characteristics of speech, and therefore it allows the prediction residuals to be quantized with less distortion for a given number of bits. In addition it can easily be used with vector quantization to further improve the quantization of the spectral amplitudes.

The invention preferably features an improved method for determining the voiced/unvoiced decisions in the presence of a high bit error rate. The bit error rate is estimated for a current speech segment and compared to a predetermined error-rate threshold, and the voiced/unvoiced decisions for spectral amplitudes above a predetermined energy threshold are all declared voiced for the current segment when the estimated bit error rate is above the error-rate threshold. This reduces the perceptual effect of bit errors. Distortions caused by switching from voiced to unvoiced are reduced.

The invention may also feature an improved method for error correction (or error detection) coding of the speech model parameters. The new method uses at least two types of error correction coding to code the quantized model parameters. A first type of coding, which adds a greater number of additional bits than a second type of coding, is used for a group of parameters that is more sensitive to bit errors. The other type of error correction coding is used for a second group of parameters that is less sensitive to bit errors than the first. Compared to existing methods, the new method improves the quality of the synthesized speech in the presence of bit errors while reducing the amount of additional error correction or detection bits which must be added. In preferred embodiments, the different types of error correction include Golay codes and Hamming codes.

The invention preferably features a further method for improving the quality of synthesized speech in the presence of bit errors. The error rate is estimated from the error correction coding, and one or more model parameters from a previous segment are repeated in a current segment when the error rate for the parameters exceeds a predetermined level. In preferred embodiments, all of the model parameters are repeated.

The invention may also feature a new method for reducing the degradation caused by the estimation and quantization of the model parameters. This new method uses a frequency domain representation of the spectral envelope parameters to enhance regions of the spectrum which are perceptually important and to attenuate regions of the spectrum which are perceptually insignificant. The result is that degradaion in the synthesized speech is reduced. A smoothed spectral envelope of the segment is generated by smoothing the spectral envelope, and an enhanced spectral envelope is generated by increasing some frequency regions of the spectral envelope for which the spectral envelope has greater amplitude than the smoothed envelope and decreasing some frequency regions for which the spectral envelope has lesser amplitude than the smoothed envelope. In preferred embodiments, the smoothed spectral envelope is generated by estimating a low-order model (e.g. an all-pole model) from the spectral envelope. Compared to existing methods this new method is more computationally efficient for frequency domain speech coders. In addition this new method improves speech quality by removing the frequency domain constraints imposed by time-domain methods.

Other features and advantages of the invention will be apparent from the following description of preferred embodiments

In the drawings:-

Figures 1-2 are diagrams showing prior art speech coding methods.

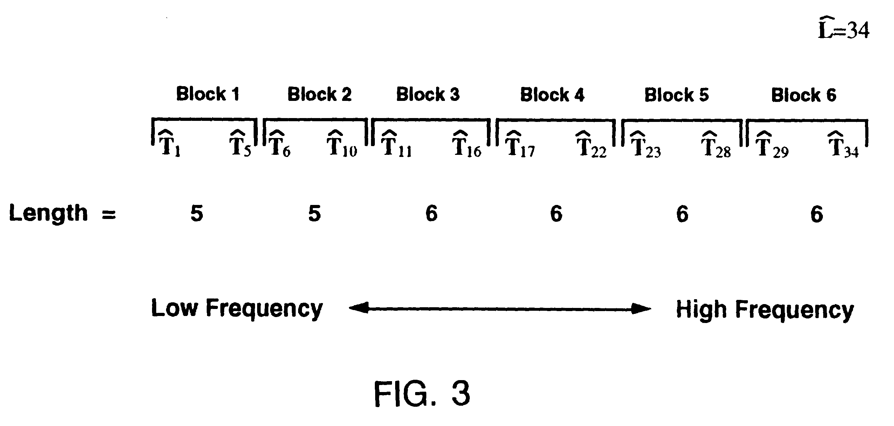

Figure 3 is a flow chart showing a preferred embodiment of the invention in which the spectral amplitude prediction accounts for any change in the fundamental frequency

Figure 4 is a flow chart showing a preferred embodiment of the invention in which the spectral amplitudes are divided into a fixed number of blocks

Figure 5 is a flow chart showing a preferred embodiment of the invention in which a prediction residual block average vector is formed.

Figure 6 is a flow chart showing a preferred embodiment of the invention in which the prediction residual block average vector is vector quantized

Figure 7 is a flow chart showing a preferred embodiment of the invention in which the prediction residual block average vector is quantized with a DCT and scalar quantization.

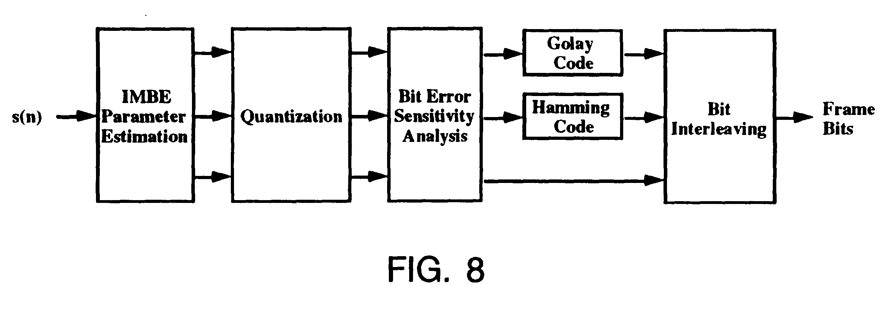

Figure 8 is a flow chart showing a preferred embodiment of the invention encoder in which different error correction codes are used for different model parameter bits.

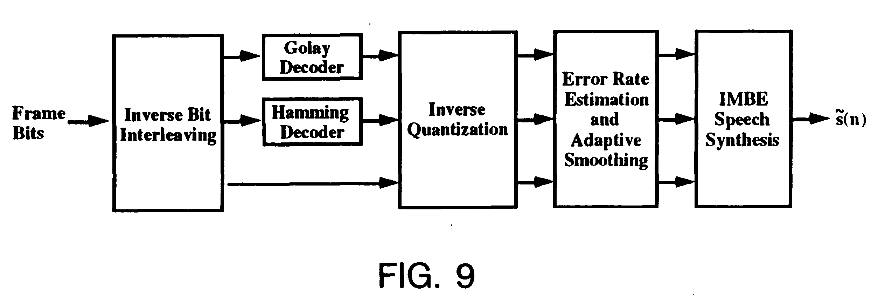

Figure 9 is a flaw chart showing a preferred embodiment of the invention decoder in which different error correction codes are used for different model parameter bits.

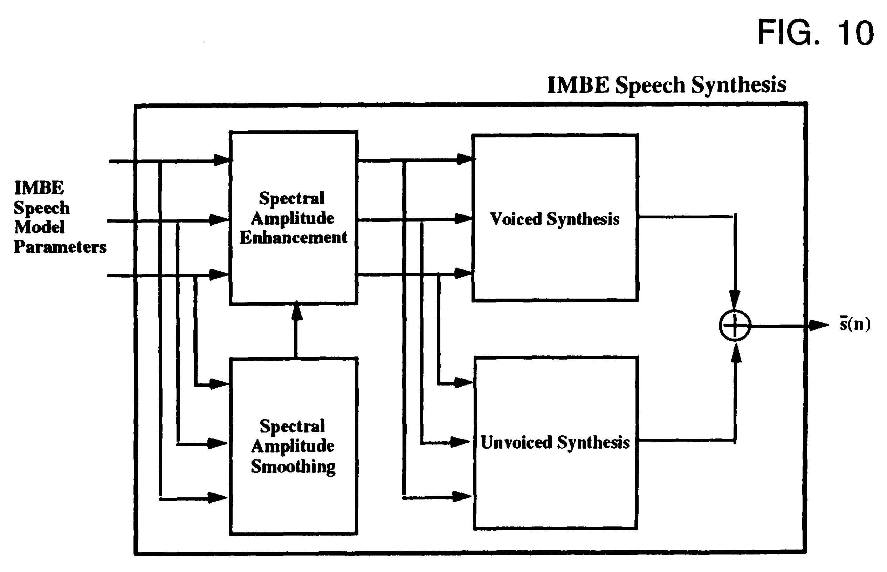

Figure 10 is a flow chart showing a preferred embodiment of the invention in which frequency domain spectral envelope parameter enhancement is depicted.

In the prior art, the spectral amplitude prediction residuals were formed using Equation (2). This method does not account for any change in the fundamental frequency between the previous segment and current segment. In order to account for the change in the fundamental frequency a new method has been developed which first interpolates the spectral amplitudes of the previous segment. This is typically done using linear interpolation, however various other forms of interpolation could also be used. Then the interpolated spectral amplitudes of the previous segment are resampled at the frequency points corresponding to the multiples of the fundamental frequency of the current segment. This combination of interpolation and resampling produces a set of predicted spectral amplitudes, which have been corrected for any inter-segment change in the fundamental frequency.

Typically a fraction of the base two logarithm of the predicted spectral amplitudes is subtracted from the base two logarithm of the spectral amplitudes of the current segment. If linear interpolation is used to compute the predicted spectral amplitudes, then this can be expressed mathematically as:

$$\dot{T}_l = \log_2 \dot{M}_l^0 - \gamma \left[ (1 - \delta_l) \log_2 \dot{M}_{k_l}^{-1} + \delta_l \log_2 \dot{M}_{k_l+1}^{-1} \right] \qquad (8)$$

where $\delta_l$ is given V,

$$\delta_l = \frac{\hat{\omega}_0^0}{\hat{\omega}_0^{-1}} \cdot l - \lfloor \frac{\hat{\omega}_0^0}{\hat{\omega}_0^{-1}} \cdot l \rfloor \qquad (9)$$

where $\gamma$ is a constant subject to $0 \le \gamma \le 1$. Typically, $\gamma = .7$, however other values of $\gamma$ can also be used. For example $\gamma$ could be adaptively changed from segment to segment in order to improve performance. The parameters $\hat{\omega}_0^0$ and $\hat{\omega}_0^{-1}$ in Equation (9) refer to the fundamental frequency of the current segment and the previous segment, respectively. In the case where the two fundamental frequencies are the same, the new method is identical to the old method. In other cases the new method produces a prediction residual with lower variance than the old method. This allows the prediction residuals to be quantized with less distortion for a given number of bits.

In another aspect of the invention a new method has been developed to divide the spectral amplitude prediction residuals into blocks. In the old method the $\hat{L}$ prediction residuals from the current segment were divided into blocks of $K$ elements. where $K = 8$ is a typical value. Using this method, the characteristics of each block were found to be significantly different for large and small values of $\hat{L}$. This reduced the quantization efficiency, thereby increasing the distortion in the spectral amplitudes. In order to make the characteristics of each block more uniform, a new method was divised which divides the $\hat{L}$ prediction residuals into a fixed number of blocks. The length of each block is chosen such that all blocks within a segment have nearly the same length, and the sum of the lengths of all the blocks within a segment equal $\hat{L}$. Typically the total number of prediction residuals is divided into 6 blocks, where the length of each block is equal to

$$\lfloor \frac{\hat{L}}{6} \rfloor.$$

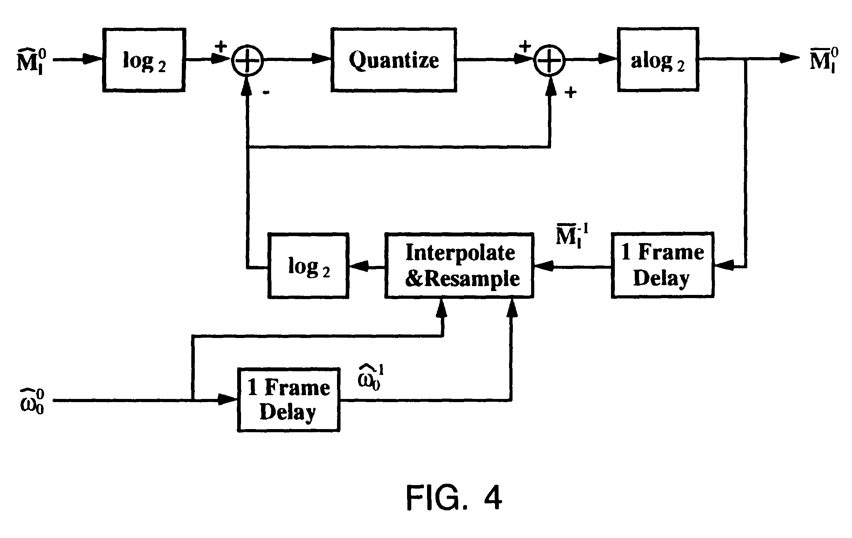

If $\hat{L}$ is not evenly divisible by 6 then the length of one or more higher frequency blocks is increased by one, such that all of the spectral magnitudes are included in one of the six blocks. This new method is shown in Figure 4 for the case where 6 blocks are used and $\hat{L} = 34$. In this new method the approximate percentage of the prediction residuals contained in each block is independent of $\hat{L}$. This reduces the variation in the characteristics of each block, and it allows more efficient quantization of the prediction residuals.

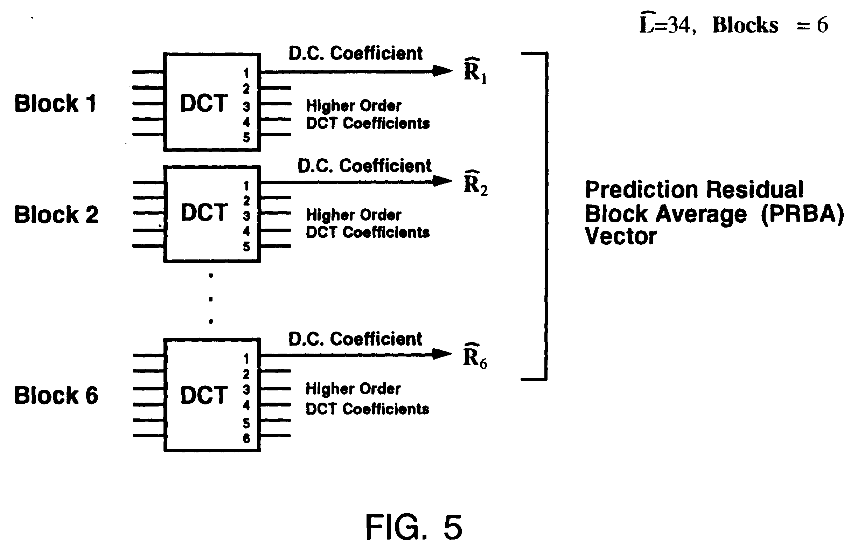

The quantization of the prediction residuals can be further improved by forming a prediction residual block average (PRBA) vector. The length of the PRBA vector is equal to the number of blocks in the current segment. The elements of this vector correspond to the average of the prediction residuals within each block. Since the first DCT coefficient is equal to the average (or D.C. value), the PRBA vector can be formed from the first DCT coefficient from each block. This is shown in Figure 5 for the case where 6 blocks are present in the current segment and $\hat{L} = 34$. This process can be generalized by forming additional vectors from the second (or third, fourth, etc.) DCT coefficient from each block.

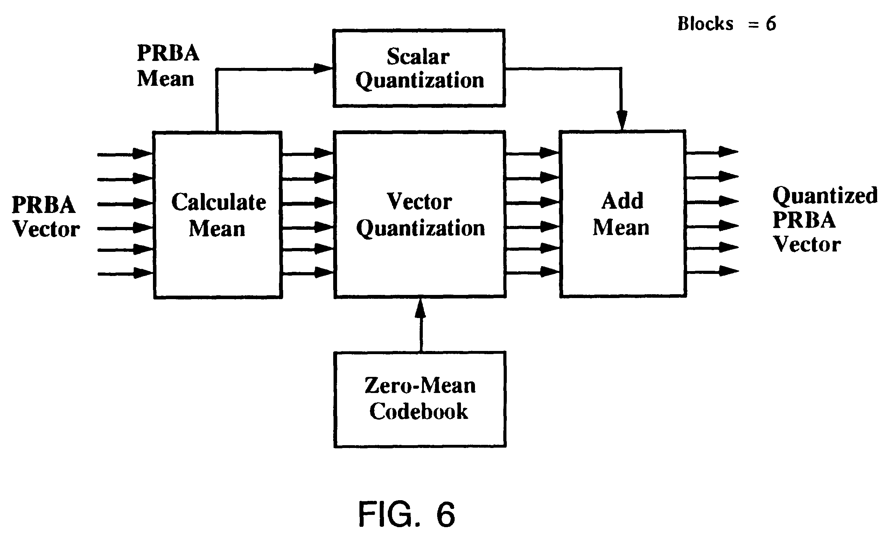

The elements of the PRBA vector are highly correlated. Therefore a number of methods can be used to improve the quantization of the spectral amplitudes. One method which can be used to achieve very low distortion with a small number of bits is vector quantization. In this method a codebook is designed which contains a number of typical PRBA vectors. The PRBA vector for the current segment is compared against each of the codebook vectors, and the one with the lowest error is chosen as the quantized PRBA vector. The codebook index of the chosen vector is used to form the binary representation of the PRBA vector. A method for performing vector quantization of the PRBA vector has been developed which uses the cascade of a 6 bit non-uniform quantizer for the mean of the vector, and a 10 bit vector quantizer for the remaining information. This method is shown in Figure 6 for the case where the PRBA vector always contains 6 elements. Typical values for the 6 bit and 10 bit quantizers are given in the attached appendix.

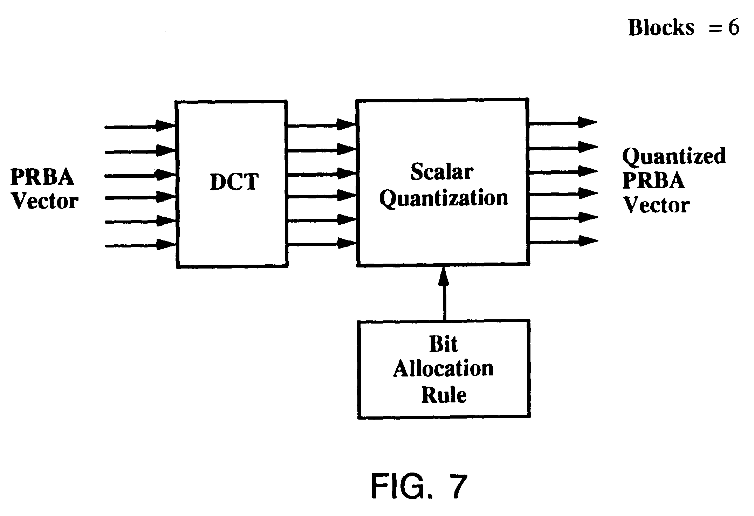

An alternative method for quantizing the PRBA vector has also been developed. This method requires less computation and storage than the vector quantization method. In this method the PRBA vector is first transformed with a DCT as defined in Equation (3). The length of the DCT is equal to the number of elements in the PRBA vector. The DCT coefficients are then quantized in a manner similar to that discussed in the prior art. First a bit allocation rule is used to distribute the total number of bits used to quantize the PRBA vector among the DCT coefficients. Scalar quantization (either uniform or non-uniform) is then used to quantize each DCT coefficient using the number of bits specified by the bit allocation rule. This is shown in Figure 7 for the case where the PRBA vector always contains 6 elements.

Various other methods can be used to efficiently quantize the PRBA vector. For example other transforms such as the Discrete Fourier Transform, the Fast Fourier Transform, the Karhunen-Louve Transform could be used instead of the DCT. In addition vector quantization can be combined with the DCT or other transform. The improvements derived from this aspect of the invention can be used with a wide variety of quantization methods.

In another aspect a new method for reducing the perceptual effect of bit errors has been developed. Error correction codes are used as in the prior art to correct infrequent bit errors and to provide an estimate of the error rate $\varepsilon_R$. The new method uses the estimate of the error rate to smooth the voiced/unvoiced decisions, in order to reduce the perceived effect of any remaining bit errors. This is done by first comparing the error rate against a threshold which signifies the rate at which the distortion from uncorrected bit errors in the voiced/unvoiced decisions is significant. The exact value of this threshold depends on the amount of error correction applied to the voiced/unvoiced decisions, but a threshold value of .003 is typical if little error correction has been applied. If the estimated error rate, $\varepsilon_R$, is below this threshold then the voiced/unvoiced decisions are not perturbed. If $\varepsilon_R$ is above this threshold then every spectral amplitude for which Equation (10) is satisfied is declared voiced.

$$\bar{M}_l > \begin{cases} \dfrac{45.255(S_E)^{.375}}{exp(173.29\varepsilon_R)} & \text{if } .003 < \varepsilon_R \leq .02 \\[2mm] 1.414(S_E)^{.375} & \text{if } \varepsilon_R > .02 \end{cases} \tag{10}$$

Although Equation (10) assumes a threshold value of .003, this method can easily be modified to accommodate other thresholds. The parameter $S_E$ is a measure of the local average energy contained in the spectral amplitudes. This parameter is typically updated each segment according to:

$$S_E = \begin{cases} .95\, S_E + .05\, R_0 & \text{if } .95\, S_E + .05\, R_0 \leq 10000.0 \\[2mm] 10000.0 & \text{otherwise} \end{cases} \tag{11}$$

where $R_0$ is given by,

$$R_0 = \sum_{l=1}^{\hat{L}} \tilde{M}_l^2 \tag{12}$$

The initial value of $S_E$ is set to an arbitrary initial value in the range $0 \leq S_E \leq 10000.0$. The purpose of this parameter is to reduce the dependency of Equation (10) on the average signal level. This ensures that the new method works as well for low level signals as it does for high level signals.

The specific forms of Equations (10), (11) and (12) and the constants contained within them can easily be modified, while maintaining the essential components of the new method. The main components of this new method are to first use an estimate of the error rate to determine whether the voiced/unvoiced decisions need to be smoothed. Then if smoothing is required, the voiced/unvoiced decisions are perturbed such that all high energy spectral amplitudes are declared voiced. This eliminates any high energy voiced to unvoiced or unvoiced to voiced transitions between segments, and as a result it improves the perceived quality of the reconstructed speech in the presence of bit errors.

In our invention we divide the quantized speech model parameter bits into three or more different groups according to their sensitivity to bit errors, and then we use different error correction or detection codes for each group. Typically the group of data bits which is determined to be most sensitive to bit errors is protected using very effective error correction codes. Less effective error correction or detection codes, which require fewer additional bits, are used to protect the less sensitive data bits. This new method allows the amount of error correction or detection given to each group to be matched to its sensitivity to bit errors. Compared to the prior art, this method has the advantage that the degradation caused by bit errors is reduced and the number of bits required for forward error correction is also reduced.

The particular choice of error correction or detection codes which is used depends upon the bit error statistics of the transmission or storage medium and the desired bit rate. The most sensitive group of bits is typically protected with an effective error correction code such as a Hamming code, a BCH code, a Golay code or a Reed-Solomon code. Less sensitive groups of data bits may use these codes or an error detection code. Finally the least sensitive groups may use error correction or detection codes or they may not use any form of error correction or detection. The invention is described herein using a particular choice of error correction and detection codes which was well suited to a 6.4 kbps IMBE speech coder for satellite communications.

In the 6.4 kbps IMBE speech coder, which was standardized for the INMARSAT-M satellite communciation system, the 45 bits per frame which are reserved for forward error correction are divided among [23,12] Golay codes which can correct up to 3 errors, [15,11] Hamming codes which can correct single errors and parity bits. The six most significant bits from the fundamental frequency and the three most significant bits from the mean of the PRBA vector are first combined with three parity check bits and then encoded in a [23,12] Golay code. A second Golay code is used to encode the three most significant bits from the PRBA vector and the nine most sensitive bits from the higher order DCT coefficients. All of the remaining bits except the seven least sensitive bits are then encoded into five [15,11] Hamming codes. The seven least significant bits are not protected with error correction codes.

Prior to transmission the 128 bits which represent a particular speech segment are interleaved such that at least five bits separate any two bits from the same code word. This feature spreads the effect of short burst errors over several different codewords, thereby increasing the probability that the errors can be corrected.

At the decoder the received bits are passed through Golay and Hamming decoders which attempt to remove any bit errors from the data bits. The three parity check bits are checked and if no uncorrectable bit errors are detected then the received bits are used to reconstruct the MBE model parameters for the current frame. Otherwise if an uncorrectable bit error is detected then the received bits for the current frame are ignored and the model parameters from the previous frame are repeated for the current frame.

The use of frame repeats has been found to improve the perceptual quality of the speech when bit errors are present. Thus, we examine each frame of received bits and determine, whether the current frame is likely to contain a large number of uncorrectable bit errors. One method used to detect uncorrectable bit errors is to check extra parity bits which are inserted in the data. Thus, we also determine whether a large burst of bits errors has been encountered by comparing the number of correctable bit errors with the local estimate of the error rate. If the number of correctable bit errors is substantially greater than the local estimate of the error rate then a frame repeat is performed. Additionally, we check each frame for invalid bit sequences (i.e. groups of bits which the encoder never transmits). If an invalid bit sequence is detected a frame repeat is performed.

The Golay and Hamming decoders also provide information on the number of correctable bit errors in the data. This information is used by the decoder to estimate the bit error rate. The estimate of the bit error rate is used to control adaptive smoothers which increase the perceived speech quality in the presence of uncorrectable bit errors. In addition the estimate of the error rate can be used to perform frame repeats in bad error environments.

This aspect of the invention can be used with soft-decision coding to further improve performance. Soft-decision decoding uses additional information on the likelihood of each bit being in error to improve the error correction and detection capabilities of many different codes. Since this additional information is often available from a demodulator in a digital communication system, it can provide improved robustness to bit errors without requiring additional bits for error protection.

We use a new frequency domain parameter enhancement method which improves the quality of synthesized speech. We first locate the perceptually important regions of the speech spectrum. We then increase the amplitude of the perceptually important frequency regions relative to other frequency regions. The preferred method for performing frequency domain parameter enhancement is to smooth the spectral envelope to estimate the general shape of the spectrum. The spectrum can be smoothed by fitting a low-order model such as an all-pole model, a cepstral model, or a polynomial model to the spectral envelope. The smoothed spectral envelope is then compared against the unsmoothed spectral envelope and perceptually important spectral regions are identified as regions where the unsmoothed spectral envelope has greater energy than the smoothed spectral envelope. Similarly regions where the unsmoothed spectral envelope has less energy than the smoothed spectral envelope are identified as perceptually less important. Parameter enhancement is performed by increasing the amplitude of perceptually important frequency regions and decreasing the amplitude of perceptually less important frequency regions. This new enhancement method increases speech quality by eliminating or reducing many of the artifacts which are introduced during the estimation and quantization of the speech parameters. In addition this new method improves the speech intelligibility by sharpening the perceptually important speech formants.

In the IMBE speech decoder a first-order all-pole model is fit to the spectral envelope for each frame. This is done by estimating the correlation parameters. $R_0$ and $R_1$ from the decoded model parameters according to the following equations.

$$R_0 = \sum_{l=1}^{\hat{L}} \hat{M}_l^2 \tag{13}$$

$$R_1 = \sum_{l=1}^{\hat{L}} \hat{M}_l^2 \cos(\hat{\omega}_0 l) \tag{14}$$

where $\hat{M}_l$ for $1 \le l \le \hat{L}$ are the decoded spectral amplitudes for the current frame, and $\hat{\omega}_0$ is the decoded fundamental frequency for the current frame. The correlation parameters $R_0$ and $R_1$ can be used to estimate a first-order all-pole model. This model is evaluated at the frequencies corresponding to the spectral amplitudes for the current frame (i.e. $k \cdot \hat{\omega}_0$ for $1 \le l \le \hat{L}$) and used to generate a set of weights $W_l$ according to the following formula.

$$W_l = \sqrt{\tilde{M}_l} \cdot \left[ \frac{.96\pi(R_0^2 + R_1^2 - 2R_0R_1 \cos(\hat{\omega}_0 l))}{\hat{\omega}_0 R_0 (R_0^2 - R_1^2)} \right]^{1/4} \qquad \text{for } 1 \le l \le \hat{L} \tag{15}$$

These weights indicate the ratio of the smoothed all-pole spectrum to the IMBE spectral amplitudes. They are then used to individually control the amount of parameter enhancement which is applied to each spectral amplitude. This relationship is expressed in the following equation,

$$\tilde{M}_l = \begin{cases} 1.2 \cdot \hat{M}_l & \text{if } W_l > 1.2 \\ W_l \cdot \hat{M}_l & \text{otherwise} \end{cases} \qquad \text{for } 1 \le l \le \hat{L} \tag{16}$$

where $\tilde{M}_l$ for $1 \le l \le \hat{L}$ are the enhanced spectral amplitudes for the current frame.

The enhanced spectral amplitudes are then used to perform speech synthesis. The use of the enhanced model parameters improves speech quality relative to synthesis from the unenhanced model parameters.

Further description of a particular embodiment of speech coding system employing this invention can be found in the document entitled "INMARSAT M Voice Codec", a copy of which has been placed in the file of this Application.

**Claims**

1.   A method of encoding speech wherein the speech is broken into segments, each of said segments representing one of a succession of time intervals and having a spectrum of frequencies, and for each segment the spectrum is sampled at a set of frequencies to form a set of actual spectral amplitudes, with the frequencies at which the spectrum is sampled generally differing from one segment to the next, and wherein the spectral amplitudes for at least one previous segment are used to produce a set of predicted spectral amplitudes for a current segment, and wherein a set of prediction residuals for the current segment based on a difference between the actual spectral amplitudes for the current segment and the predicted spectral amplitudes for a current segment are used in subsequent encoding, characterized in that the prediction residuals for a segment are grouped into blocks, an average of the prediction residuals within each block is determined, the averages of each of the blocks are grouped into a prediction residual block average (PRBA) vector, and the PRBA vector is encoded.

2.   The method of Claim 1, wherein there are a predetermined number of blocks, with the number of blocks being independent of the number of prediction residuals grouped into particular blocks.

3.   The method of Claim 2, wherein the predicted spectral-amplitudes for the current segment are based at least in part on interpolating the spectral amplitudes of a previous segment to estimate the spectral amplitudes in the previous segment at the frequencies of the current segment.

4.   The method of any one of the preceding claims, wherein the difference between the actual spectral amplitudes for the current segment and the predicted spectral amplitudes for the current segment is formed by subtracting a fraction of the predicted spectral amplitudes from the actual spectral amplitudes.

5.   The method of any one of the preceding claims, wherein the spectral amplitudes are obtained using a Multi-Band Excitation speech model.

6.   The method of any one of the preceding claims, wherein only spectral amplitudes from the most recent previous segment are used in forming the predicted spectral amplitudes of the current segment.

7.   The method of any one of the preceding claims, wherein said spectrum comprises a fundamental frequency and the set of frequencies for a given segment are multiples of the fundamental frequency of the segment.

8. The method of any one of Claims 2 or 3, wherein the number of prediction residuals in a lower frequency block is not larger than the number of prediction residuals in a higher frequency block.

9. The method of any one of Claims 2, 3 or 8, wherein the number of blocks is equal to six (6).

10. The method of Claim 9, wherein the difference between the number of elements in the highest frequency block and the number of elements in the lowest frequency block is less than or equal to one.

11. The method of any one of the preceding claims, wherein said average is computed by adding the prediction residuals within the block and dividing by the number of prediction residuals within that block.

12. The method of Claim 11, wherein said average is obtained by computing a Discrete Cosine Transform (DCT) of the spectral amplitude prediction residuals within a block and using the first coefficient of the DCT as the average.

13. The method of any one of the preceding claims, wherein encoding the PRBA vector comprises vector quantizing the PRBA vector.

14. The method of Claim 13, wherein said vector quantization is performed using a method comprising the steps of:

determining an average of the PRBA vector;
quantizing said average using scalar quantization;
subtracting said average from the PRBA vector to form a zero-mean PRBA vector; and
quantizing said zero-mean PRBA vector using vector quantization with a zero-mean codebook.

15. The method of any one of the preceding claims, wherein the PRBA vector is encoded using a liner transform on the PRBA vector and scalar quantizing the transform coefficients.

16. The method of Claim 15, wherein said linear transform comprises a Discrete Cosine Transform.

17. The method according to any one of the preceding claims, in which the predicted spectral amplitudes for the current segment are based at least in part on interpolating the spectral amplitudes of a previous segment to estimate the spectral amplitudes in the previous segment at the frequencies of the current segment.

18. The method according to any one of the preceding claims, in which the number of blocks is independent of the number of residuals for particular blocks.

19. The method of Claim 18, wherein the predicted spectral amplitudes for the current segment are based at least in part on interpolating the spectral amplitudes of a previous segment to estimate the spectral amplitudes in the previous segment at the frequencies of the current segment.

20. The method according to any one of the preceding claims, in which a bit error rate is estimated for a current speech segment and compared to a predetermined error-rate threshold, the voiced/unvoiced decisions for spectral amplitudes above a predetermined energy threshold are all declared voiced for the current segment when the estimated bit error rate is above the error-rate threshold.

21. The method of Claim 20, wherein the predetermined energy threshold is dependent on the estimate of bit error rate for the current segment.

22. The method of any one of the preceding claims, wherein the speech is encoded using a speech model characterized by model parameters, wherein the speech is broken into time segments and for each segment model parameters are estimated and quantized, and wherein at least some of the quantized model parameters are coded using error correction coding, at least two types of error correction coding are used to code the quantized model parameters, a first type of coding, which adds a greater number of additional bits than a second type of coding, is used for a first group of quantized model parameters, which is more sensitive to bit errors than a second group of quantized model parameters.

23. The method of Claim 22, wherein the different types of error correction coding include Golay codes and Hamming codes.

24. The method of any one of the preceding claims, wherein the speech is encoded using a speech model characterized by model parameters, wherein the speech is broken into time segments and for each segment model parameters are estimated and quantized, wherein at least some of the quantized model parameters are coded using error correction coding, and wherein speech is synthesized from the decoded quantized model parameters, the error correction coding is used in synthesis to estimate the error rate, and one or more model parameters from a previous segment are repeated in a current segment when the error rate for the parameter exceeds a predetermined level.

25. The method of any one of Claims 22 to 24, wherein the quantized model parameters are those associated with the Multi-Band Excitation (MBE) speech coder or Improved Multi-Band Excitation (IMBE) speech coder.

26. The method of Claim 22 or 23, wherein error rates are estimated using the error correction codes.

27. The method of Claim 26, wherein one or more model parameters are smoothed across a plurality of segments based on estimated error rate.

28. The method of Claim 27, wherein the model parameters smoothed include voiced/unvoiced decisions.

29. The method of Claim 27, wherein the model parameters smoothed include parameters for the Multi-Band Excitation (MBE) speech coder or Improved Multi-Band Excitation (IMBE) speech coder.

30. The method of Claim 29, wherein the value of one or more model parameters in a previous segment are repeated in a current segment when the estimated error rate for the parameters exceeds a predetermined level.

31. The method according to any one of the preceding claims of enhancing speech wherein a speech signal is broken into segments, and wherein frequency domain representations of a segment is determined to provide a spectral envelope of the segment, and speech is synthesized from an enhanced spectral envelope, a smoothed spectral envelope of the segment is generated by smoothing the spectral envelope, and an enhanced spectral envelope is generated by increasing some frequency regions of the spectral envelope for which the spectral envelope has greater amplitude than the smoothed envelope and decreasing some frequency regions for which the spectral envelope has lesser amplitude than the smoothed envelope.

32. The method of Claim 31, wherein the frequency domain representation of the spectral envelope is the set of spectral amplitude parameters of the Multi-Band Excitation (MBE) speech order or Improved Multi-Band Excitation (IMBE) speech coder.

33. The method of Claim 26 or 32, wherein the smoothed spectral envelope is generated by estimating a low-order model from the spectral envelope.

34. The method of Claim 33, wherein the low-order model is an all-pole model.

**Patentansprüche**

1. Verfahren zum Codieren von Sprache, wobei die Sprache in Segmente zerlegt wird, wobei jedes der Segmente eines von einer Folge von Zeitintervallen darstellt und ein Spektrum von Frequenzen aufweist, und für jedes Segment das Spektrum bei einer Gruppe von Frequenzen abgetastet wird, um eine Gruppe von tatsächlichen Spektralamplituden zu bilden, wobei sich die Frequenzen, bei denen das Spektrum abgetastet wird, im allgemeinen von einem Segment zum nächsten unterscheiden, und wobei die Spektralamplituden für mindestens ein vorheriges Segment verwendet werden, um eine Gruppe von vorhergesagten Spektralamplituden für ein aktuelles Segment zu erzeugen, und wobei eine Gruppe von Vorhersageabweichungen für das aktuelle Segment auf der Basis einer Differenz zwischen den tatsächlichen Spektralamplituden für das aktuelle Segment und den vorhergesagten Spektralamplituden für ein aktuelles Segment bei der anschließenden Codierung verwendet wird, dadurch gekennzeichnet, daß die Vorhersageabweichungen für ein Segment in Blöcke gruppiert werden, ein Mittelwert der Vorhersageabweichungen innerhalb jedes Blocks bestimmt wird, die Mittelwerte von jedem der Blöcke zu einem Vorhersageabweichungsblock-Mittelwert-(PRBA)-Vektor gruppiert werden und der PRBA-Vektor codiert wird.

2. Verfahren nach Anspruch 1, wobei es eine vorbestimmte Anzahl von Blöcken gibt, wobei die Anzahl der Blöcke von der Anzahl der in spezielle Blöcke gruppierten Vorhersageabweichungen unabhängig ist.

3. Verfahren nach Anspruch 2, wobei die vorhergesagten Spektralamplituden für das aktuelle Segment zumindest teilweise auf der Interpolation der Spektralamplituden eines vorherigen Segments basieren, um die Spektralamplituden in dem vorherigen Segment bei den Frequenzen des aktuellen Segments abzuschätzen.

4. Verfahren nach einem der vorangehenden Ansprüche, wobei die Differenz zwischen den tatsächlichen Spektralamplituden für das aktuelle Segment und den vorhergesagten Spektralamplituden für das aktuelle Segment durch Subtrahieren eines Bruchteils der vorhergesagten Spektralamplituden von den tatsächlichen Spektralamplituden gebildet wird.

5. Verfahren nach einem der vorangehenden Ansprüche, wobei die Spektralamplituden unter Verwendung eines Mehrbandanregungs-Sprachmodells erhalten werden.

6. Verfahren nach einem der vorangehenden Ansprüche, wobei nur Spektralamplituden von dem letzten vorherigen Segment bei der Bildung der vorhergesagten Spektralamplituden des aktuellen Segments verwendet werden.

7. Verfahren nach einem der vorangehenden Ansprüche, wobei das Spektrum eine Grundfrequenz umfaßt und die Gruppe von Frequenzen für ein gegebenes Segment Vielfache der Grundfrequenz des Segments sind.

8. Verfahren nach einem der Ansprüche 2 oder 3, wobei die Anzahl der Vorhersageabweichungen in einem Block mit niedrigerer Frequenz nicht größer ist als die Anzahl der Vorhersageabweichungen in einem Block mit höherer Frequenz.

9. Verfahren nach einem der Ansprüche 2, 3 oder 8, wobei die Anzahl der Blöcke gleich sechs (6) ist.

10. Verfahren nach Anspruch 9, wobei die Differenz zwischen der Anzahl der Elemente im Block mit der höchsten Frequenz und der Anzahl der Elemente im Block mit der niedrigsten Frequenz weniger als oder gleich Eins ist.

11. Verfahren nach einem der vorangehenden Ansprüche, wobei der Mittelwert durch Addieren der Vorhersageabweichungen innerhalb des Blocks und Dividieren durch die Anzahl der Vorhersageabweichungen innerhalb dieses Blocks berechnet wird.

12. Verfahren nach Anspruch 11, wobei der Mittelwert durch Berechnen einer Diskreten Cosinustransformation (DCT) der Spektralamplituden-Vorhersageabweichungen innerhalb eines Blocks und Verwenden des ersten Koeffizienten der DCT als Mittelwert erhalten wird.

13. Verfahren nach einem der vorangehenden Ansprüche, wobei die Codierung des PRBA-Vektors die Vektorquantisierung des PRBA-Vektors umfaßt.

14. Verfahren nach Anspruch 13, wobei die Vektorquantisierung unter Verwendung eines Verfahrens durchgeführt wird, welches die folgenden Schritte umfaßt:

Bestimmen eines Mittelwerts des PRBA-Vektors;
Quantisieren des Mittelwerts unter Verwendung einer Skalarquantisierung;
Subtrahieren des Mittelwerts vom PRBA-Vektor, um einen PRBA-Vektor mit einem Mittelwert von Null zu bilden; und
Quantisieren des PRBA-Vektors mit einem Mittelwert von Null unter Verwendung einer Vektorquantisierung mit einem Codebuch mit Mittelwert Null.

15. Verfahren nach einem der vorangehenden Ansprüche, wobei der PRBA-Vektor unter Verwendung einer linearen Transformation des PRBA-Vektors und einer Skalarquantisierung der Transformationskoeffizienten codiert wird.

16. Verfahren nach Anspruch 15, wobei die lineare Transformation eine Diskrete Cosinustransformation umfaßt.

17. Verfahren nach einem der vorangehenden Ansprüche, wobei die vorhergesagten Spektralamplituden für das aktuelle Segment zumindest teilweise auf der Interpolation der Spektralamplituden eines vorherigen Segments basieren, um die Spektralamplituden in dem vorherigen Segment bei den Frequenzen des aktuellen Segments abzuschätzen.

18. Verfahren nach einem der vorangehenden Ansprüche, wobei die Anzahl der Blöcke von der Anzahl der Abweichungen für spezielle Blöcke unabhängig ist.

19. Verfahren nach Anspruch 18, wobei die vorhergesagten Spektralamplituden für das aktuelle Segment zumindest teilweise auf der Interpolation der Spektralamplituden eines vorherigen Segments basieren, um die Spektralamplituden in dem vorherigen Segment bei den Frequenzen des aktuellen Segments abzuschätzen.

20. Verfahren nach einem der vorangehenden Ansprüche, wobei eine Bitfehlerrate für ein aktuelles Sprachsegment abgeschätzt und mit einer vorbestimmten Fehlerratenschwelle verglichen wird und die Entscheidungen Stimme/keine Stimme für Spektralamplituden oberhalb einer vorbestimmten Energieschwelle alle als Stimme für das aktuelle Segment deklariert werden, wenn die abgeschätzte Bitfehlerrate über der Fehlerratenschwelle liegt.

21. Verfahren nach Anspruch 20, wobei die vorbestimmte Energieschwelle von der Abschätzung der Bitfehlerrate für das aktuelle Segment abhängt.

22. Verfahren nach einem der vorangehenden Ansprüche, wobei die Sprache unter Verwendung eines Sprachmodells codiert wird, welches durch Modellparameter gekennzeichnet ist, wobei die Sprache in Zeitsegmente zerlegt wird und für jedes Segment Modellparameter abgeschätzt und quantisiert werden, und wobei zumindest einige der quantisierten Modellparameter unter Verwendung einer Fehlerkorrekturcodierung codiert werden, mindestens zwei Arten einer Fehlerkorrekturcodierung verwendet werden, um die quantisierten Modellparameter zu codieren, und eine erste Codierungsart, die eine größere Anzahl von zusätzlichen Bits hinzufügt als eine zweite Codierungsart, für eine erste Gruppe von quantisierten Modellparametern verwendet wird, die gegenüber Bitfehlern empfindlicher ist als eine zweite Gruppe von quantisierten Modellparametern.

23. Verfahren nach Anspruch 22, wobei die verschiedenen Arten der Fehlerkorrekturcodierung Golay-Codes und Hamming-Codes umfassen.

24. Verfahren nach einem der vorangehenden Ansprüche, wobei die Sprache unter Verwendung eines Sprachmodells codiert wird, welches durch Modellparameter gekennzeichnet ist, wobei die Sprache in Zeitsegmente zerlegt wird und für jedes Segment Modellparameter abgeschätzt und quantisiert werden, wobei zumindest einige der quantisierten Modellparameter unter Verwendung einer Fehlerkorrekturcodierung codiert werden, und wobei die Sprache aus den decodierten quantisierten Modellparametern synthetisiert wird, die Fehlerkorrekturcodierung bei der Synthese verwendet wird, um die Fehlerrate abzuschätzen, und einer oder mehrere Modellparameter von einem vorherigen Segment in einem aktuellen Segment wiederholt werden, wenn die Fehlerrate für den Parameter eine vorbestimmte Stufe übersteigt.

25. Verfahren nach einem der Ansprüche 22 bis 24, wobei die quantisierten Modellparameter jene sind, die zum Mehrbandanregungs-(MBE)-Sprachcodierer oder zum verbesserten Mehrbandanregungs-(IMBE)-Sprachcodierer gehören.

26. Verfahren nach Anspruch 22 oder 23, wobei die Fehlerraten unter Verwendung der Fehlerkorrekturcodes abgeschätzt werden.

27. Verfahren nach Anspruch 26, wobei einer oder mehrere Modellparameter über eine Vielzahl von Segmenten auf der Basis der abgeschätzten Fehlerrate geglättet werden.

28. Verfahren nach Anspruch 27, wobei die geglätteten Modellparameter Entscheidungen Stimme/keine Stimme umfassen.

29. Verfahren nach Anspruch 27, wobei die geglätteten Modellparameter Parameter für den Mehrbandanregungs-(MBE)-Sprachcodierer oder den verbesserten Mehrbandanregungs-(IMBE)-Sprachcodierer umfassen.

30. Verfahren nach Anspruch 29, wobei der Wert von einem oder mehreren Modellparametern in einem vorherigen Segment in einem aktuellen Segment wiederholt wird, wenn die abgeschätzte Fehlerrate für die Parameter eine vorbestimmte Stufe überschreitet.

31. Verfahren nach einem der vorangehenden Ansprüche zum Verbessern von Sprache, wobei ein Sprachsignal in Segmente zerlegt wird und wobei Frequenzbereichsdarstellungen eines Segments bestimmt werden, um eine Spektralhüllkurve des Segments bereitzustellen, und die Sprache aus einer verbesserten Spektralhüllkurve synthetisiert wird, eine geglättete Spektralhüllkurve des Segments durch Glätten der Spektralhüllkurve erzeugt wird, und eine verbesserte Spektralhüllkurve durch Erhöhen einiger Frequenzbereiche der Spektralhüllkurve, für die die Spektralhüllkurve eine größere Amplitude besitzt als die geglättete Hüllkurve, und Verringern einiger Frequenzbereiche, für die die Spektralhüllkurve eine geringere Amplitude besitzt als die geglättete Hüllkurve, erzeugt wird.

32. Verfahren nach Anspruch 31, wobei die Frequenzbereichsdarstellung der Spektralhüllkurve die Gruppe der Spektralamplitudenparameter des Mehrbandanregungs-(MBE)-Sprachcodierers oder des verbesserten Mehrbandanregungs-(IMBE)-Sprachcodierers ist.

33. Verfahren nach Anspruch 26 oder 32, wobei die geglättete Spektralhüllkurve durch Abschätzen eines Modells niedriger Ordnung von der Spektralhüllkurve erzeugt wird.

34. Verfahren nach Anspruch 33, wobei das Modell niedriger Ordnung ein Allpolmodell ist.

## Revendications

1. Un procédé de codage de la parole dans lequel la parole est découpée en segments, chacun desdits segments représentant l'un parmi une suite d'intervalles de temps et présentant un spectre de fréquences, et pour chaque segment, le spectre est échantillonné à une pluralité de fréquenceS afin de former un jeu d'amplitudes spectrales réelles, les fréquences d'échantillonnage du spectre se différenciant généralement d'un segment au suivant, et dans lequel les amplitudes spectrales pour au moins un segment précédent sont utilisées pour produire un jeu d'amplitudes spectrales prédites pour un segment en cours, et dans lequel on exploite dans le codage ultérieur un jeu de résidus de prédiction pour le segment en cours, basés sur la différence entre les amplitudes spectrales réelles pour le segment en cours et les amplitudes spectrales prédites pour un segment en cours, caractérisé en ce qu'on regroupe en blocs les résidus de prédiction pour un segment, on détermine une moyenne des résidus de prédiction à l'intérieur de chaque bloc, on regroupe les moyennes de chacun des blocs dans un vecteur des moyennes des blocs des résidus de prédiction (PRBA), et on effectue le codage du vecteur PRBA.

2. Le procédé selon la revendication 1, dans lequel il existe un nombre prédéterminé de blocs, le nombre de blocs étant indépendant du nombre de résidus de prédiction regroupés dans des blocs particuliers.

3. Le procédé selon la revendication 2, dans lequel les amplitudes spectrales prédites pour le segment en cours, sont basées, au moins en partie, sur l'interpolation des amplitudes spectrales d'un segment précédent, pour estimer les amplitudes spectrales dans le segment précédent aux fréquences du segment en cours.

4. Le procédé selon l'une quelconque des revendications précédentes, dans lequel on forme la différence entre les amplitudes spectrales réelles pour le segment en cours et les amplitudes spectrales prédites pour le segment en cours, en soustrayant une fraction des amplitudes spectrales prédites des amplitudes spectrales réelles.

5. Le procédé selon l'une quelconque des revendications précédentes, dans lequel on obtient les amplitudes spectrales en utilisant un modèle de la parole à excitation multibande.

6. Le procédé selon l'une quelconque des revendications précédentes, dans lequel on n'utilise que des amplitudes spectrales à partir du segment précédent le plus récent, pour former les amplitudes spectrales prédites du segment en cours.

7. Le procédé selon l'une quelconque des revendications précédentes, dans lequel ledit spectre comprend une fréquence fondamentale et le jeu des fréquences pour un segment donné sont des multiples de la fréquence fondamentale du segment.

8. Le procédé selon l'une quelconque des revendications 2 ou 3, dans lequel le nombre de résidus de prédiction dans un bloc de fréquences plus basses n'est pas supérieur au nombre de résidus de prédiction dans un bloc de fréquences plus élevées.

9. Le procédé selon l'une quelconque des revendications 2, 3 ou 8, dans lequel le nombre de blocs est égal à six (6).

10. Le procédé selon la revendication 9, dans lequel la différence entre le nombre d'éléments dans le bloc à fréquence la plus élevée et le nombre d'éléments dans le bloc à fréquence la plus basse est inférieur ou égal à un.

11. Le procédé selon l'une quelconque des revendications précédentes, dans lequel on calcule ladite moyenne par sommation des résidus de prédiction dans le bloc et division par le nombre de résidus de prédiction dans ce bloc.

12. Le procédé selon la revendication 11, dans lequel on obtient ladite moyenne par calcul d'une transformée en Cosinus Diserète (DCT) des résidus de prédiction d'amplitude spectrale dans un bloc, et en prenant comme moyenne le premier coefficient de la DCT.

13. Le procédé selon l'une quelconque des revendications précédentes, dans lequel le codage du vecteur PRBA comprend la quantification vectorielle du vecteur PRBA.

14. Le procédé selon la revendication 13, dans lequel ladite quantification vectorielle est effectuée en utilisant un procédé comprenant les étapes consistant :

à déterminer une moyenne du vecteur PRBA :
a quantifier ladite moyenne en utilisant une quantification scalaire :
à soustraire ladite moyenne du vecteur PRBA pour former un vecteur PRBA à moyenne nulle ; et
à quantifier ledit vecteur PRBA à moyenne nulle en utilisant la quantification vectorielle avec une table de codes à moyenne nulle.

15. Le procédé selon l'une quelconque des revendications précédentes, dans lequel on code le vecteur PRBA en utilisant une transformée linéaire du vecteur PRBA avec une quantification scalaire des coefficients de la transformée.

16. Le procédé selon la revendication 15, dans lequel ladite transformée linéaire comprend une transformée en cosinus discrète.

17. Le procédé selon l'une quelconque des revendications précédentes, dans lequel les amplitudes spectrales prédites pour le segment en cours sont basées, au moins en partie, sur l'interpolation des amplitudes spectrales d'un segment précédent, afin d'estimer les amplitudes spectrales dans le segment précédent aux fréquences du segment en cours.

18. Le procédé selon l'une quelconque des revendications précédentes, dans lequel le nombre de blocs est indépendant du nombre de résidus pour des blocs particuliers.

19. Le procédé selon la revendication 18, dans lequel les amplitudes spectrales prédites pour le segment en cours sont basées, au moins en partie, sur l'interpolation des amplitudes spectrales d'un segment précédent, afin d'estimer les amplitudes spectrales dans le segment précédent aux fréquences du segment en cours.

20. Le procédé selon l'une quelconque des revendications précédentes, dans lequel on effectue l'estimation d'un taux d'erreurs sur les bits pour un segment de parole en cours et on le compare à un seuil prédéterminé du taux d'erreurs, et on déclare comme toutes voisées les décisions voisées/non voisées pour des amplitudes spectrales au-dessus d'un seuil prédéterminé d'énergie pour le segment en cours. lorsque le taux d'erreurs estimé sur les bits est supérieur au seuil du taux d'erreurs.

21. Le procédé selon la 20, dans lequel le seuil prédéterminé d'énergie dépend de l'estimation du taux d'erreurs sur les bits pour le segment en cours.

22. Le procédé selon l'une quelconque des revendications précédentes, dans lequel on code la parole en utilisant un modèle de la parole caractérisé par des paramètres types, dans lequel on découpe la parole en segment de temps, et pour chaque segment, on effectue l'estimation et la quantification des paramètres types, et dans lequel on code au moins certains des paramètres types en utilisant un codage à correction d'erreurs, on utilise au moins deux types de codage à correction d'erreurs pour coder les paramètres types quantifiés, et on utilise un premier type de codage, qui ajoute un plus grand nombre de bits supplémentaires qu'à un deuxième type de codage, pour un premier groupe de paramètres types quantifiés, groupe qui est plus sensible à des erreurs sur les bits qu'un deuxième groupe de paramètres types quantifiés.

**23.** Le procédé selon la revendication 22, dans lequel les différents types de codage à correction d'erreurs comprennent des codes de Golay et des codes de Hamming.

**24.** Le procédé selon l'une quelconque des revendications précédentes, dans lequel on code la parole en utilisant un modèle de la parole caractérisé par des paramètres types, dans lequel on découpe la parole en segments de temps et pour chaque segment, on effectue une estimation et une quantification des paramètres types, dans lequel on code au moins certains des paramètres types quantifiés en utilisant un codage à correction d'erreurs, et dans lequel on synthétise la parole à partir des paramètres types quantifiés décodés, on utilise le codage à correction d'erreurs pour la synthèse afin d'estimer le taux d'erreurs, et on répète un ou plusieurs paramètres types à partir d'un segment précédent dans un segment en cours, lorsque le taux d'erreurs pour le paramètre dépasse un niveau prédéterminé.

**25.** Le procédé selon l'une quelconque des revendications 22 à 24, dans lequel les paramètres types sont ceux qui sont associés au codeur de la parole à excitation multibande (MBE) ou au codeur de la parole à excitation multibande améliorée (IMBE).

**26.** Le procédé selon les revendications 22 ou 23, dans lequel on effectue l'estimation des taux d'erreurs en utilisant des codes correcteurs d'erreurs.

**27.** Le procédé selon la revendication 26, dans lequel un ou plusieurs paramètres types sont lissés sur une pluralité de segments, à partir d'un taux d'erreurs estimé.

**28.** Le procédé selon la revendication 27, dans lequel les paramètres types lissés comprennent des décisions voisées/non voisées.

**29.** Le procédé selon la revendication 27, dans lequel les paramètres types lissés comprennent des paramètres pour le codeur de la parole à excitation multibande (MBE) ou pour le codeur de la parole à excitation multibande améliorée (IMBE).

**30.** Le procédé selon la revendication 29, dans lequel on répète la valeur d'un ou plusieurs paramètres types pour un segment précédent dans un segment en cours lorsque le taux d'erreurs estimé pour les paramètres dépasse un niveau prédéterminé.

**31.** Le procédé selon l'une quelconque des revendications précédentes pour l'amélioration de la parole, dans lequel on découpe en segments un signal de la parole, et dans lequel des représentations dans le domaine fréquentiel d'un segment sont déterminées pour fournir une enveloppe spectrale du segment, et on synthétise la parole à partir d'une enveloppe spectrale améliorée, on génère une enveloppe spectrale lissée du segment en effectuant le lissage de l'enveloppe spectrale, et on génère une enveloppe spectrale améliorée en augmentant certaines zones fréquentielles de l'enveloppe spectrale, pour lesquelles l'enveloppe spectrale présente une amplitude supérieure à celle de l'enveloppe lissée, et on diminue certaines zones fréquentielles pour lesquelles l'enveloppe spectrale présente une amplitude inférieure à celle de l'enveloppe lissée.

**32.** Le procédé selon la revendication 31, dans lequel la représentation dans le domaine fréquentiel de l'enveloppe spectrale est le jeu de paramètres d'amplitude spectrale du codeur de la parole à excitation multibande (MBE) ou du codeur de la parole à excitation multibande améliorée (IMBE).

**33.** Le procédé selon la revendication 26 ou 32, dans lequel on génère l'enveloppe spectrale lissée en estimant un modèle d'ordre faible à partir de l'enveloppe spectrale.

**34.** Le procédé selon la revendication 33, dans lequel le modèle d'ordre faible est un modèle ne présentant que des pôles.

s(n) →

**MBE
Speech
Analysis**

fundamental
frequency →

voiced/unvoiced
decisions →

spectral
amplitudes →

spectral
phases →

**MBE
Parameter
Quantization**

→
→
→
→

**MBE
Speech
Synthesis**

→ ŝ(n)

PRIOR ART
**FIG. 1**

# FIG. 2

$\widehat{L}=34$

| Block 1 | Block 2 | Block 3 | Block 4 | Block 5 |
|---|---|---|---|---|
| $\widehat{T}_1 \quad \widehat{T}_8$ | $\widehat{T}_9 \quad \widehat{T}_{16}$ | $\widehat{T}_{17} \quad \widehat{T}_{24}$ | $\widehat{T}_{25} \quad \widehat{T}_{32}$ | $\widehat{T}_{33} \quad \widehat{T}_{34}$ |

Length =   8        8        8        8        2

Low Frequency ◄─────────► High Frequency

EP 0 560 931 B1

$$\widehat{L}=34$$

| Block 1 | Block 2 | Block 3 | Block 4 | Block 5 | Block 6 |
|---|---|---|---|---|---|
| $\widehat{T}_1 \quad \widehat{T}_5$ | $\widehat{T}_6 \quad \widehat{T}_{10}$ | $\widehat{T}_{11} \quad \widehat{T}_{16}$ | $\widehat{T}_{17} \quad \widehat{T}_{22}$ | $\widehat{T}_{23} \quad \widehat{T}_{28}$ | $\widehat{T}_{29} \quad \widehat{T}_{34}$ |

Length =     5        5        6        6        6        6

Low Frequency   ⟷   High Frequency

FIG. 3

EP 0 560 931 B1

FIG. 4

EP 0 560 931 B1

$$\hat{L} = 34, \quad \text{Blocks} = 6$$

**Block 1** — DCT 1 2 3 4 5 — D.C. Coefficient → $\hat{R}_1$

Higher Order DCT Coefficients

**Block 2** — DCT 1 2 3 4 5 — D.C. Coefficient → $\hat{R}_2$

Higher Order DCT Coefficients

**Block 6** — DCT 1 2 3 4 5 6 — D.C. Coefficient → $\hat{R}_6$

Higher Order DCT Coefficients

Prediction Residual Block Average (PRBA) Vector

FIG. 5

EP 0 560 931 B1

FIG. 6

EP 0 560 931 B1

Blocks = 6

FIG. 7

EP 0 560 931 B1

FIG. 8

EP 0 560 931 B1

FIG. 9

FIG. 10

IMBE Speech Synthesis